# EUROPEAN PATENT APPLICATION

(11) **EP 2 757 474 A2**
(43) Date of publication of application: **23.07.2014**
(21) Application number: 13179612.0
(22) Date of filing: 07.08.2013
(51) Int. Cl.: G06F 9/50, G06F 11/34

(54) **Adaptive virtualization**

(30) Priority: 18.01.2013 US 201313744572
(71) Applicant: Mitel Networks Corporation, Ottawa, ON K2K 2W7 (CA)
(72) Inventor: Yeung, Michael, Nepean, Ontario K2G 6R6 (CA); Bootland, Thomas C, Arnprior, Ontario K7S 1R0 (CA); Gray, Tom, Mansfield, Québec J0X 1R0 (CA)
(74) Representative: Derry, Paul Stefan

(57) **Abstract**

A method for a computing apparatus, of adopting virtualization resource requirements is provided. Performance indicators at least in part related to a virtualized application are received and a vendor model is updated based on the received performance indicators. The method also allows for generating, based on the updated vendor model, updated resource requirement estimates for the virtualized application. The updated resource requirements serve as a basis for sending, to a cloud service provider, a capacity change request based on the updated resource requirement estimates. The timing for generating and sending updates is managed by an adaptation module and is based on an update policy. The update policy itself can be based on schedules that reflect estimated capacity changes for the virtualized application. The updating can be based on a learning module which can use Kalman filters and other techniques for learning.

## Description

### FIELD OF THE INVENTION

The present invention relates generally to virtualization systems, and more particularly to a system and method for adaptive virtualization.

### BACKGROUND OF THE INVENTION

Virtualization is currently reshaping how systems are implemented. It offers new possibilities to vendors that design and supply systems and operators that license, purchase, use and manage them. Based on virtualization, system vendors, such as internet protocol private branch exchange (IP-PBX) vendors and other telecom system vendors, no longer have to design, manufacture and maintain specific hardware. Instead, they can design their systems to run within standard virtualization systems in standard off the shelf servers and other hardware. Vendors supply an operator who will actually operate the vended system with the appropriate software loads and needed licenses for a fee. The operator then installs and runs the vended system on servers it has access to. These can be privately owned servers running in the operator's data center or the operator can contract with a cloud service provider to rent time on servers. In the cloud case, the operator does not purchase, house or maintain the physical servers. Significant cost savings to the operator can result.

Cloud service provided servers and others which are used for the provision of virtualization can be inefficient. Inefficiencies can depend on the size and capability of the resources required to run the operator's system. If the operator contracts for excess capacity then resources are wasted. If the operator mistakenly contracts for insufficient capacity then the required application service levels will not be achieved. Currently, the resource allocation is partly addressed by use of service level requests in which the operator can specify the level of service required and the cloud service provider provides these requirements. Due to the fact that operators have varying patterns of resource usage, these requests can be inaccurate.

### BRIEF DESCRIPTION OF THE DRAWINGS

Fig. 1 shows a block diagram of an embodiment of a system for adaptive virtualization;
Fig. 2 shows a block diagram of an embodiment of a learning systems for adaptive virtualization;
Fig. 3 shows a graph of example results that can be obtained from a system for adaptive virtualization;
Fig. 4 shows a graph of example results that can be obtained from a system for adaptive virtualization; and
Fig. 5 shows a flow chart showing a method of adaptive virtualization in accordance with an embodiment.

### DETAILED DESCRIPTION OF THE PREFERRED EMBODIMENTS

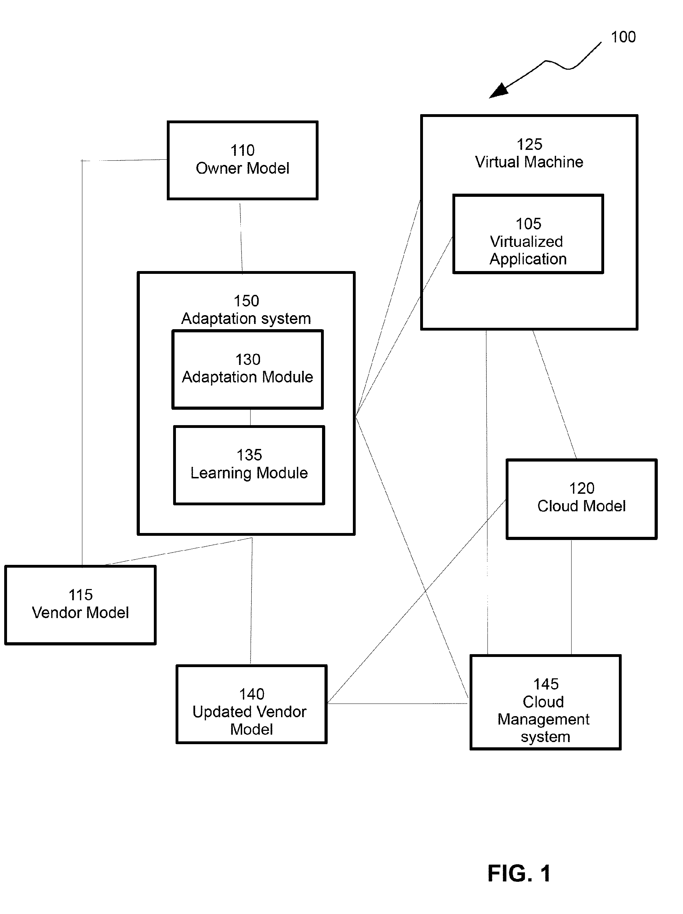

Referring now to Fig. 1 a system for adaptive virtualization is shown at 100. System 100 includes a virtualized application 105. The virtualized application 105 can be any system that can be implemented in a virtual machine (VM) 125. To illustrate system 100, an example will be used where the system being virtualized is assumed to be a voice over IP (VoIP) controller system such as an IP-PBX. It is to be understood that the present embodiments are for illustration purposes only, and is not a limitation on scope. In other embodiments and variations, virtualized application 105 can be a database system, a customer relations management systems, a web server or other systems that will now occur to a person of skill in the art that can be implemented as part of a VM.

Continuing with Fig. 1, for a specific virtualized application 105 to be implemented, the operator of the implemented virtualized application 105 can develop an operator/owner model 110 for determining the specific configuration of the virtualized application 105 needed by the operator. The operator model 110, for example, can be developed on the basis of an estimate of the amount, type and level of services required. Accordingly, the operator model 110 can be a table of time based estimates of configuration factors for specific time periods during which the system is in use. Configuration factors can be factors such as usage behaviors, use of specific applications and features, maximum size, load and other factors that can be used to specify requirements for a specific system. Configuration factors can include, for example, a maximum size for the system, the features requested, feature options for specific features and the estimated usage for the features and their options.

Continuing with the example for an IP-PBX operator, an example operator model 110 can include configuration factors for the number of users of specific types such as the number of automatic call center distribution (ACD) agents, the number of office phones and others, as well as a required quality and quantity of service.

In some embodiments, operator model 110 can be implemented on any computing apparatus, such as a server, a desktop computer, a virtual machine or any other computing apparatus, individual or distributed, that will now occur to a person of skill in the art. Operator model 110 can be generated through various operations, both manual and automated, including by rule based model generators and others that will now occur to a person of skill in the art.

Continuing with Fig. 1, a vendor model 115 is a model provided by a system vendor. The purpose of the vendor model 115 is to provide estimates for the resources required for specific system configurations under conditions of varying load or capacity needs. Accordingly, a vendor model 115 is a model that can generate estimates of the server and other resource requirements to meet various possible capacity needs and other service requirements for a specific configuration of the system vended by a vendor. Vendor model 115 is typically supplied by the vendor along with the vended system to be virtualized.

In some embodiments, vendor model 115 can be implemented on any computing apparatus, such as a server, a desktop computer, a virtual machine or any other apparatus, individual or distributed, that will now occur to a person of skill in the art. In variations, vendor model 115 can be resident on computing apparatus operated by the vendor and accessed through a network. In other variations, vendor model 115 can be resident on computing apparatus operated by the operator, and accessed through a network. Other variations of how the vendor model 115 can be vended and operated will now occur to a person of skill in the art.

The estimated resources can include, for example, number of servers, computing power, mass storage, short-term storage or local memory, network capacity and network latency. The estimated resources can be specified precisely. For example, it can be specified that 100 megabytes of mass storage is needed. In variations, estimated resources can be specified with varying levels of granularity. For example, mass storage may be specified with a coarse level of granularity such as small, medium and large. Alternatively, the estimated resources can be specified with a finer granularity, such as in increments of 100 million instructions per second (MIPs) for computing power. Other resources that can be estimated and mechanisms of specifying such estimates will now occur to a person of skill in the art and are within scope.

Configuration factors specifying a specific system can be used in cooperation with the vendor model 115 to estimate resources for that specific system. For example, vendor model can be used, in cooperation with the operator model 110, to estimate required virtualization services needed from a cloud service provider. Accordingly, the operator model 110 can be used to provide at least some of the configuration factors to vendor model 115. In a variation, the operator model 110 can be used to index into the vendor model 115 to determine the required resources. In a further variation, the operator model 110 can contain a translation element that can convert the contents of the operator model 110 into the syntax and semantics required for communicating with the vendor model 115 to supply data. In yet a further variation, a table or rule-set or such similar mechanisms can be used to perform the conversion. In other embodiments, at least some of the configuration factors can be derived by the vendor model 115 based on data obtained from operator model 110, which can include some other configuration factors. In further embodiments, operator model 110 can be linked to multiple different vendor models provided either by the same vendor or by different vendors. Accordingly, different resource estimates generated by each vendor model 115 can be used in choosing amongst vendors, or different systems provided by the same vendor or both.

In the present example where the vendor is a vendor of an IP-PBX system, the vendor model identifies the resource requirements for a specific IP-PBX system based on the configuration factors for that specific system as specified, at least in part, by the operator model 110 and other factors negotiated. In the present example, configuration factors include a maximum size for the system which is the maximum number of system users. The configuration factors for the example further include features requested which are the specific user types such as ACD agents, secretarial stations, office phones, and others. The example configuration factors further include feature options for specific user types such as unified messaging, voice mail and other options specified for each user. The example configuration factors additionally include an estimated usage for user types such as the number of calls per hour per user. Additional example configuration factors can be based on quality and service levels required such as factors needed for obtaining a certain media quality.

The estimation performed by vendor model 115 can be multi-dimensional with resource requirements dependent on each of the configuration factors as dimensions. Estimates can be based on the clustering of these dimensions or configuration factors. Accordingly, for any specific system configuration, an estimate of the resources required can be generated on the basis of the grouping together of related configuration factors to get a means for generating estimates. The configuration factors or dimensions can include the number of ACD agents with their selected feature capabilities, the number of office users with unified messaging, and others that can be can be clustered.

Various configurations of features can represent individual dimensions in a multi-dimensional space. For example, a first axis can represent various feature types and a second axis can represent maximum usage for that feature type. Thus, in this example, each feature cluster will have its own two dimensions: the type of feature and maximum possible usage of such a feature. To illustrate, the feature cluster could be ACD agents with the dimension of a feature set and maximum size of ACD operation. Continuing with the example, a third axis can represent the resources required for a currently offered load for a feature cluster of a specified maximum size or load. Accordingly, in this example, the third axis represents the current resource usage for a specific configuration of a system of a certain maximum size under various conditions of load. Once many clusters for many features are considered, this representation becomes a highly dimensional matrix of resource estimates.

A vendor model 115 can be generated from a set of rules supplied by the vendor. Tables representing vendor model 115 can be physically instantiated at system start up or table values may be generated on demand during the operation of the vended system. The tables may be highly dimensional and very large and so some embodiments may instantiate the tables only for the configurations and load or needed capacity ranges that are expected to be applicable for specific systems as opposed to all possible systems.

Continuing with Fig. 1, a cloud service provider, can use a cloud model 120, to identify a capacity to allocate to a virtual machine 125 based on resource requirements specified. Typically, virtual machine 125 is set up on within a private data center of the cloud service provider. The private data center of the cloud service provider can include servers, networks and storage units, as well as other components which will now occur to a person of skill in the art. Capacity allocation is accomplished by allocating a portion of the capacity of its data center to the virtual machine such that the allocated capacity closely matches the capacity identified by cloud model 120. Accordingly, virtual machine 125 can be executing at a single data center or in a mirrored form across a plurality of data centers.

The cloud service provider can supply the operator with the required addresses and authorization keys and other appropriate access items necessary to access the virtual machine 125. In other embodiments, other methods of setting up a virtual machine 125 can be used. Using the supplied access items operator can place the virtualized application105 within the virtual machine 125. Once the virtualized application 105 is set up within the allocated virtual machine 125, the operator can accordingly begin to operate and offer services to its own internal and/or external users. In variations, the virtual machine can be set up in data centers or servers that are operated by other entities such as the operator itself.

Resource estimates generated by vendor model 115 can be used in cooperation with cloud model 120 to identify capacity to allocate. For example, cloud model 120 can be used, in cooperation with the vendor model 115, to identify and allocate the required virtualized resources. In this example, the vendor model 115 can be used to provide at least part of the inputs to cloud model 120. In a variation, the vendor model 115 can contain a translation element that will convert the resource estimates into the syntax and semantics required by a cloud model 120. In a further variation, a table or rule-set or such similar mechanisms can be used to perform the conversion. In other embodiments, at least a part of the resource estimates can be derived by the cloud model 120 based on the data obtained from the vendor model 115.

In some embodiments, cloud model 120 can be implemented on any computing apparatus, such as a server, a desktop computer, a virtual machine or any other apparatus, individual or distributed, that will now occur to a person of skill in the art. In variations, cloud model 120 can be resident on computing apparatus operated by the cloud service provider, and accessed through a network. In other variations, cloud model 120 can be resident on computing apparatus operated by the operator or the vendor, and accessed through a network. Other variations of operating and accessing cloud model 120 will now occur to a person of skill in the art.

In some embodiments, the capacity allocated to virtual machine 125 can be updated as the requirements of virtualized application 105 change. The updating of an operator's resource usage can create a burden on the private operations of the cloud services provider. A high rate of change in resource allocations can create a churn in the private operations that can create instability and require a non-optimal allocation of physical resources. Accordingly, in variations, there can be restrictions on the number, frequency or timing of virtual machine 125 capacity allocation updates. So, for example, a cloud service provider may allow only a certain number of updates per day, or require that the frequency of updates be kept below a predetermined value, or that updates to be made only at certain times of day. These restrictions may be very stringent so that only a few updates can be made per day or very liberal so that updates can be made every few seconds. Cloud service provider restrictions can be a capacity factor in determining how often the capacity allocation of virtual machine 125 can be updated.

In some embodiments, there can be a delay between the time of completion of the system resource estimation and the time that the resource usage is supplied by the cloud service provider. In some cases of manual communication of the resource estimate, this delay could be in the order of several hours. In other cases, the delay could only be a few seconds. This delay can be an additional capacity factor in determining how often the capacity allocation of virtual machine 125 can be updated.

In additional embodiments, the cloud provider may charge for capacity allocation updates. This may be a charge for individual updates which may increase with the rate or number of updates. Alternatively, the charges can be based on the amount timing and frequency of updates. These costs can be an additional capacity factor in determining how often the capacity allocation of virtual machine 125 can be updated.

Continuing with Fig. 1, an adaptation module is indicated at 130. The adaptation module 130 can include policies which indicate when and how often resource updates should be requested for virtual machine 125. The number and timing of updates can be represented by update policies. Update Policies can be set by the operator in part based on capacity factors such as cloud service restrictions, delays, costs and other capacity factors which will now occur to a person of skill in the art. Update policies, can additionally be based on change requirements of the virtualized application 105. For example, to maximize efficiency of resource use, updates to allocated capacity for virtual machine 125 can be requested frequently. Alternatively, with systems where resource changes are costly, or where there is a large delay between request and allocation of capacity, the requests for update can be carried out infrequently.

Update policies can also be based on schedules that reflect estimated resource and capacity requirements of a virtualized application 105. For example, update policies can be based on historical data which can then be used as a way of anticipating application specific capacity need or load behavior during certain time of the day. Accordingly, a system operator may know when changes in load or capacity needs for virtualized application 105 occur. For example, daily backup operation in the middle of the night require more input/output and networking capacity to ensure backup operation is completed in timely manner with minimal impact to the normal operation of the application. As a further example, at the start of the day, majority of call center agents may login to the call center server within a short period of time, thus increasing the volume of calls handled. Update policies can be set up to predict the need for additional capacity needs during the start of the day to support larger agents login requests. In another example, the schedule for resource and capacity requirement changes can be learned based on historical capacity need or load statistics. In further examples, the schedules can be self- adjusting. Update policies can be set up to reflect these learned and self-adjusting schedules. It will now occur to a person of skill in the art that there are other means of predicting capacity changes on which update policies can be based. These are within scope.

Adaptation module 130 can be implemented on any computing apparatus, such as a server, a desktop computer, a virtual machine or any other apparatus, individual or distributed, that will now occur to a person of skill in the art. In variations, adaptation module 130 can be resident on computing apparatus operated by the vendor and accessed through a network. In other variations, adaptation module 130 can be resident on computing apparatus operated by the operator, and accessed through a network. Other variations of how the adaptation module 130 can be operated will now occur to a person of skill in the art.

Continuing with Fig. 1, a learning module 135 is shown which can take indications of resource usage, or performance indicators, from various components of system 100, interpret these and modify the existing vendor model to generate an updated vendor model 140. The updated vendor model 140 can in turn be used to generate updated resource estimates to reflect the current state of the running system. Accordingly, the learning module 135 functions by taking performance indications from various components of system 100 and transforming these into updated resources requirements for a specific service level that is stored in an updated vendor model 140. The updated vendor model 140 can be stored in the same format as that of vendor model 115 described previously. Moreover, the updated vendor model 140 can be written to a new store. Accordingly, at system initialization, vendor model 115 obtained from the vendor is stored permanently but the vendor model 115 is also be copied to another store as the updated vendor model 140, as shown in Fig 1. Thus, the updated vendor model 140 that is used in the initial resource request is a copy of the vendor model 115. Subsequently, updated vendor model 140 becomes the repository for the learned resource requirements and used for capacity allocation update requests and vendor model 115 is not changed. In a variation, the updated vendor model 140 can overwrite the original vendor model 115. In this variation, the original vendor model is not preserved, and hence system 100 cannot be reset to a state where learning is undone.

The updated vendor model 140 can be provided to a vendor. The vendor can refine the vendor model 115 default values based on updated model or models it received from one or more operators.

Learning module 135 can be implemented on any computing apparatus, such as a server, a desktop computer, a virtual machine or any other apparatus, individual or distributed, that will now occur to a person of skill in the art. In variations, learning module 135 can be resident on computing apparatus operated by the vendor and accessed through a network. In other variations, learning module 135 can be resident on computing apparatus operated by the operator, and accessed through a network. Other variations of how the learning module 135 can be operated will now occur to a person of skill in the art. As shown in Fig. 1, learning module 135 and adaptation module 130 can be implemented as a single adaptation system 150.

Performance indicators can originate from one or more various sources and can be accessed through various application programming interfaces (APIs), for example. These sources include the virtualized application105, the virtual machine 125 and the cloud provider's management system 145. The cloud service provider can have an internal management system 145 that can determine the performance levels of the virtualized resource that it provides to the system operator. So, for example, cloud management system 145 can monitor CPU usage, memory usage, network usage, network latency and so on. The cloud provider can provide an API to allow an operator to access this information. One example of where the services provided by the cloud management system 145 are useful is the case where virtualized application105 is exhibiting adequate performance but the reserved resource at the cloud provider is being underutilized. The operator can then reduce the requested resource level to achieve economy without sacrificing the service it requires.

The virtual machine 125 is another source of performance indicators. Virtual machine 125 can provide an indication of its internal monitoring system's detections such as whether the virtualized application 105 residing within virtual machine 125 has adequate or inadequate resource supply. Using this capability virtual machine 125 can provide a specific indicator indicating whether or not the virtual machine 125 is overloaded or exceeds the allocated capacity. Virtual machine 125 can also provide another indicator that indicates that virtual machine is approaching overload. The cloud service provider may provide an API to access this type of information from the virtual machine 125 that has been assigned to the operator.

The virtualized application 105 can also be equipped with a variety of performance indicators that are application specific performance indicators. These may be indicators of the quality of the services provided to users of virtualized application 105 or internal metrics on the operation of the virtualized application 105. The vendor or the operator can include various APIs that allow accessing the performance indicators from the virtual application 105. Continuing with the present example where virtualized application 105 is an IP-PBX system, an indicator indicating call quality can be provided. Such an indicator could provide indication of issues regarding missing and faulty packets, jitter and other quality factors affecting call quality. Other indicators could also be provided regarding the time required to offer dial tone in response to a service request or time required to cut through a connection during a specific operation of a specific feature such as call transfer. Specific internal metrics can also be provided regarding the length and stability in length of queues in media jitter buffers, throughput in transcoders, delays in acquiring specific signal processing functions such as conference units, and others that will now occur to a person of skill in the art. These indicators collectively and individually may be taken as indications of various resource usage levels such as memory allocation, network capacity, CPU capacity and others that will now occur to a person of skill in the art.

As a further illustrative example, for a virtualized web server the application specific performance indicators can include time to transmit a web page with all its content, time to create dynamic content and others. As a further example, for a virtualized email server, application specific performance indicators can include time to deliver mailbox contents to a client application or browser, time to process a new incoming email (including actions like scanning for viruses, black-list and white-list searches on sender) and others. These actions can involve significant communication with other servers and external web services.

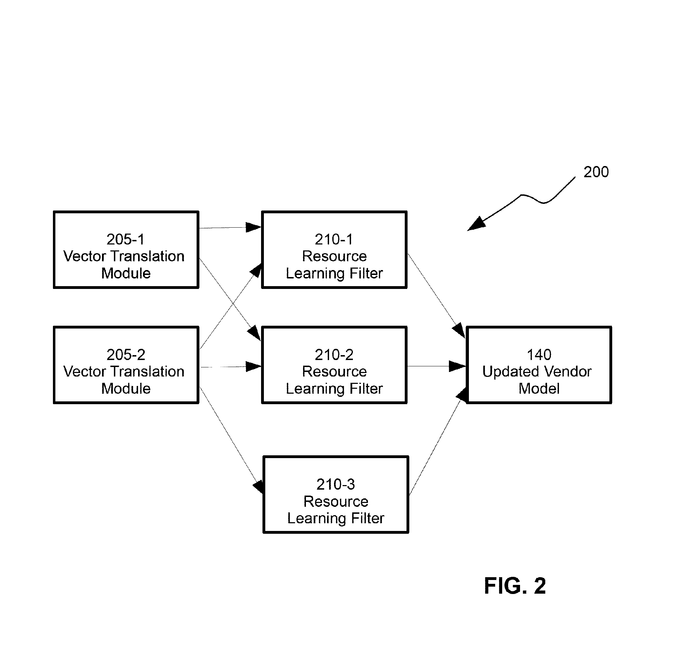

Referring now to Fig. 2, a learning system 200 is shown. Performance indicators are obtained from the various sources as described in relation to system 100 to Fig. 1. Performance indicators can be obtained through APIs provide by each source, for example. Individually or in selected groups, the performance indicators are provided to separate vector translation modules 205-1 and 205-2. Collectively, vector translation modules 205-1 and 205-2 are referred to as vector translation modules 205, and generically as vector translation module 205. This nomenclature is used elsewhere herein.

Each vector translation module 205 provides a performance estimate of over-performance or underperformance for one or more associated resources based on a comparison of the received performance indicators or groups of performance indicators to predetermined values which represent adequate performance for the associated resource or resources. The performance estimate can indicate performance ranging from greatly-missing to greatly-exceeding. The performance estimate can take the form of quantitative, qualitative or fuzzy indicators. Vector translation modules 205 can also provide confidence estimates corresponding to each performance estimate. The confidence estimates can indicate the confidence with which a performance estimate can be applied to an associated resource or a group of related resources for which the performance estimate is provided.

Continuing with Fig. 2, resource learning filters 210-1, 210-2, and 210-3 are shown. Collectively, resource learning filters 210-1, 210-2, and 210-3 are referred to as resource learning filters 210, and generically as resource learning filter 210. This nomenclature is used elsewhere herein. There is a separate resource learning filter 210 corresponding to each resource or group of related resources that can be processed together. Each resource learning filter 210 accepts performance estimates and corresponding confidence estimates for a particular resource or a group of resources corresponding to that learning filter 210. Performance estimate accepted by a resource learning filter 210 are provided by the vector translation modules 205 associated with the resources or group of resources to which that resource learning filter 210 corresponds. Resource learning filters 210 then transform the performance estimates into a single modification indicator which indicates by how much or how little the level of a resource or a group of related resources should be modified. In a variation, estimated maximum current resource requirement can also be obtained for a corresponding resource from updated vendor model 140 and used in the generation of modification indicators.

The modification indicator and the performance estimates may be fuzzy values. Accordingly, the transformation is accomplished using well known fuzzy averaging techniques that can take into account the corresponding confidence levels for each performance estimate used. In addition, another fuzzy attribute which can be used to quantify a validity which can be associated with the vector translation modules 205. Alternatively, the modification indicator and the performance estimates can take the form of qualitative or quantitative indicators and mathematical averaging, expert systems or regression techniques can be used to transform performance estimates into a modification indicator.

The modification indicators produced by the resource learning filters 210 can then be used to update the updated vendor model 140 by modifying resource estimates and other values of the updated vendor model 140, for example for a current maximum estimated load. Updates can be accomplished in different ways. For example, the modification indicator can be taken to indicate the percent or amount by which the current resource values should be updated. These and other methods of modification which will now occur to a person of skill in the art are within scope.

The function of a vector translation module 205 is to take performance indicators and translate them into a standard metric of performance which can be compared across all performance indicators. Values in this standard metric can then be used within the resource learning filters 210 to consolidate performance from all applicable performance indicators to produce a single modification indicator for a resource.

In certain embodiments, a vector translation module 205 can take the form of a table by means of which a currently measured performance indicator is translated into a standard metric value. In other embodiments, the values of performance at several instants in time may be averaged to provide a filtered estimate of performance. The standard metric estimates can be in the form of fuzzy numbers in the range from -1 to + 1. A value of 0 can indicate that the required performance level is being just met. A value of -1 will indicate that the observed performance level greatly misses the required level while a value of +1 will indicate that it is being greatly exceeded. Levels of performance between these levels will be scaled across this range. The resource learning filters 210 can then use standard fuzzy averaging techniques to consolidate fuzzy values in the standard metric for all applicable performance indicators into a single recommended modification indicator for a resource. Accordingly, the operation of the learning module 135 is substantially the same as a Kalman filter of a special type. The overall operation of system 100 comprises a feedback loop in which the updated vendor model 140 is translated into a running virtualized application105 whose performance measurements are then used to update the updated vendor model 140. Accordingly, the learning module 135 can comprise a Kalman filter which tracks the level by which each performance indicator is being met and the loop corrects this so that it tends towards o.

The updating of an updated vendor model 140 can be performed at a rate that is based on feedback and stability issues that can arise in a learning system. Updates that are too frequent can cause a learning system to thrash and never reach a stable state. Therefore updates can be performed based on a schedule or rate that reduces such learning system issues. For example, a few times per hour, the values in the updated vendor model 140 that are appropriate to the current estimated maximum load can be updated.

In some embodiments, the degree of updates performed on updated vendor model 140 for a resource can be proportional. Thus, a modification indicator that indicates a larger deviation from required levels can trigger a proportionally larger degree of change than a modification indicator which indicates a smaller deviation. In other embodiments, the modifications can also be prioritized. In other embodiments, modifications can be prioritized in accordance with priority given to certain resource requirements. For example, in some variations, performance can be prioritized, accordingly prioritizing modifications that would lead to increased resource levels and thus, increased capacity. In other variations, resource economy can be prioritized, thus prioritizing modifications that would result in reducing resource levels and accordingly, capacity. These and other methods of prioritization which will now occur to a person of skill in the art are within scope.

In some embodiments, updates can be based on capacity factors such as cost, maximum capacity and others which will now occur to a person of skill in the art. For example, in some embodiments, the updates can be based on cost. As an example, the updates can be scaled according to the cost associated with a particular resource, this leading to an updated vendor model 140 and thus a virtual machine 125 that uses less of the more costly resources. The costs used in making modification determinations for updated vendor model 140 can be static or dynamic. They can be received from the cloud service provider, or can be obtained from web sites or other repositories. Costs can vary with quantity and the modifications can be scaled in accordance with quantity. Costs can vary based on time of day or current collective usage by all clients at the cloud provider, and other parameters which will now occur to a person of skill in the art. Costs can be scaled to match these parameters.

The schedule or rate of updates for the updated vendor 140 can be communicated to the adaptation module 130, and the update policies can be adjusted to reflect the schedule or rate of vendor model update 140. Accordingly, the schedule of resource update requests to the cloud service provider for virtual machine 125 can be, at least in part, based on the update schedule of the updated vendor model 140. In variations, update policies can also be based on the learning module 135 or performance indicators. For example, update schedules can me derived on the basis of capacity need changes that are gathered by learning module 135. In further variations, the gathered capacity need changes can be based, as least in part, on information such as performance indicators, received from the virtualized application 105.

To prepare a capacity update request to cloud service provider, in some variations, adaptation module 130 can gather new values from the updated vendor model 140 for its current estimated maximum load of interest. The adaptation module 140 can translate the values taken from the updated vendor model 140 into a form that is compatible with the semantics supplied and used by the cloud service provider and initiate update negotiations, for example with cloud management system 145, accordingly. In further variations, the currently gathered values will be compared with older ones and if the change is not significant then an update will not be initiated. Significance can be determined on the basis of predetermined values or statistical measures. In some highly adaptive embodiments, update requests will be generated and sent after every access. In other embodiments updates may be limited to certain times of day, number per day or frequency or other relevant factors.

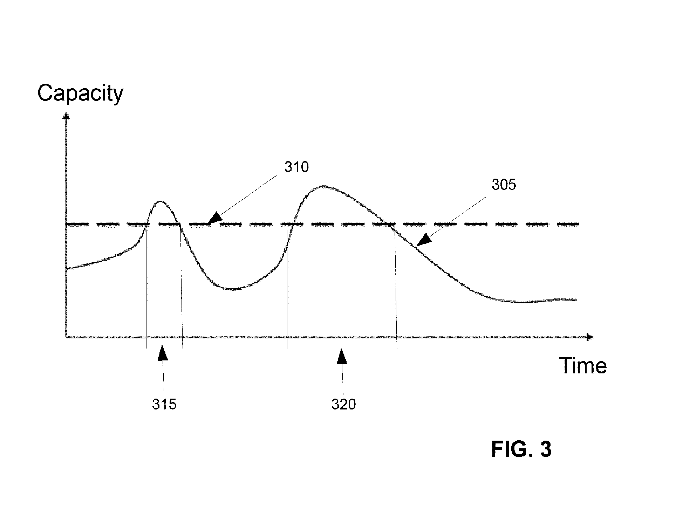

Adaptation may take place frequently or infrequently due to policies that are reflective of the offering and financial restrictions of both the operator and cloud service provider. As an example, Fig. 3 shows operational results where the resource levels are specified using coarse granularity and where delays between update request and update to resource allocations for virtual machine 125 are long. Accordingly updates to capacity allocation can take place infrequently and the resource allocation for virtual machine 125, as indicated at 310 is relatively static and matches the maximum capacity estimates of the updated vendor model 140. Mark 305 indicates the actual capacity needed.

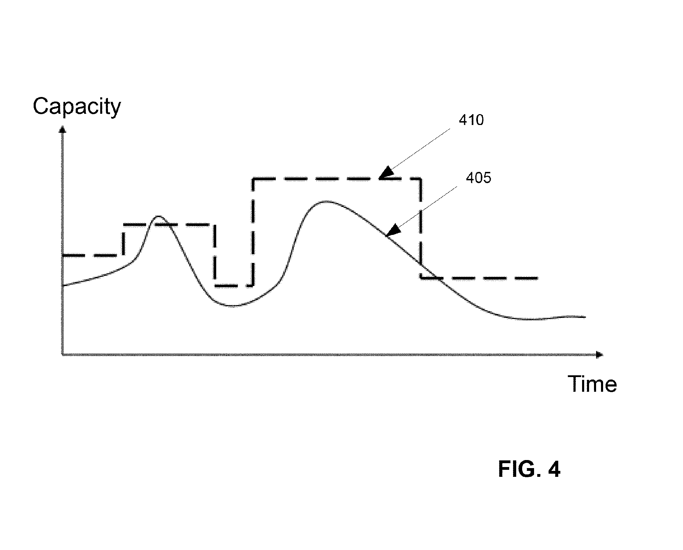

As a further example, Fig. 4 shows operational results where the resource levels are specified using fine granularity and where delays between update request and update to resource allocations for virtual machine 125 are short. Accordingly updates to capacity can take place frequently and the resource allocation for virtual machine 125, as indicated at 410 can track the actual capacity needed, as indicated at 405.

Learning process carried out by learning module 135 through updating of vendor model 140 can have greater efficiency during certain periods. For example, periods when the actual capacity needed approaches maximum capacity estimated by the updated vendor model 140 are such periods. Accordingly, the period of maximum capacity needs can be estimated by the operator model 110 and can be communicated to the learning module 135. Here. the learning process can be restricted to those periods where the maximum capacity needs are predicted, based on estimates provided by operator model 110, as indicated, for example, by periods 315 and 320 in Fig. 3. In other embodiments, learning can be continuous but various simulated capacity needs can be generated to enable the capacity needs to approach maximum estimated by the updated vendor model 140 at all times. In yet other embodiments, where frequent capacity allocation updates are possible as shown in Fig. 4, the capability can be provided so that the currently allocated capacity can be estimated and learning can take place based on the estimated allocated capacity, and when, for example maximum capacity needed approaches the estimated allocated capacity. These and other methods of optimizing learning that will now be apparent to a person of skill in the art and can be brought into effect through the use of learning policies.

In some embodiments simulated capacity needs can be provided. This can allow maximum capacity needs to be reached even in cases in which the needed capacity does not reach it. In other embodiments, the allocated capacity can be set up to a higher than expected estimated maximum capacity and simulated capacity added to exceed the needed capacity and approach the higher then estimated capacities. This can allow learning to be continuous even in embodiments where capacity updates are infrequent. In such embodiments updates will be made for the estimated maximum capacity. The learning of other capacity levels are useful in embodiments where changes the maximum capacity are specified.

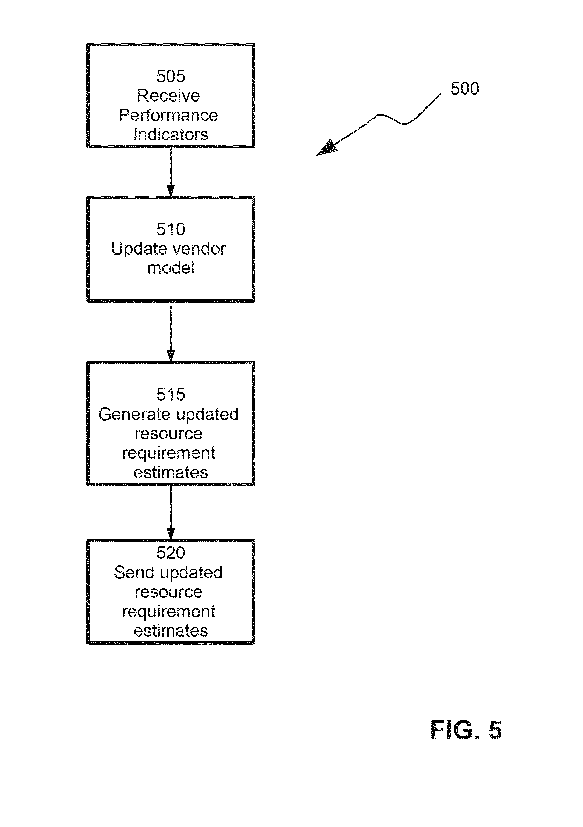

Referring now to Fig. 5 a method of adapting virtualization resource requirements is indicated at 500. In order to assist in the explanation of the method, it'll be assumed that method 500 is operated using system 100 as shown in FIG.1, and system 200 as shown in Fig. 2. Additionally, the following discussion of method 500 leads to further understanding of system 100 and system 200. However, it is to be understood that systems 100 and 200, and method 500 can be varied, and need not work exactly as discussed herein in conjunction with each other, and that such variations are within scope.

Referring back to Fig. 5 and beginning first at 505, performance indicators are received. Performance indicators can originate from one or more various sources. These sources include the virtualized application 105, the virtual machine 125 and the cloud provider's management system 145. Received performance indicators are transformed into modification indicators. Each modification indicator indicates by how much or how little the level of a resource or a group of related resources associated with that modification indicator should be modified.

Continuing with method 500, at 510, the updated vendor model 140 is updated based on the modification indicators by modifying resource estimates and other values of the updated vendor model 140. The updating can be optimized by controlling its timing and schedule through learning policies. For example, in some embodiments, the learning can be periodic and updates can performed when actual capacity needed approaches maximum capacity estimated by the updated vendor model 140. In other embodiments, learning can be continuous but various changes can be done to actual capacity needs, maximum estimated capacity, estimates of allocated capacity and others to ensure that all time periods can be brought to a state, simulated or otherwise, that are conducive to learning.

At 515, updated resource estimates are generated on the basis of updated vendor model that is modified at 510. Subsequently, at 520 updated resource estimates are translated and sent to the cloud service provided as a request for resource allocation updates to virtual machine 125. The requests may not always be successful, and can need further negotiations with, for example, cloud management system 145 before taking effect, either in original requested capacity or capacity that is altered on the basis of the negotiations. The number and timing of requests can be represented by update policies in other variations, sending the requests can be based on a signal by the operator model 110.

Although the adaption and learning modules were described as being operated by the operator, in other embodiments, these components can be operated by the vendor or the cloud service provider. For example, the operator my contract the vendor or the cloud service provider to operate the virtualized application105 as well as the learning and adaptive modules on its behalf. These and other variations are within scope.

In some variations, the resource estimates contained within the updated vendor model 140 can be extracted for study or storage and used in other systems. Thus an operator may use experience with one system to provide the initial estimates for another. In other variations, the learned estimates contained in updated vendor model 140 can be shared with other operators or the vendor, accordingly providing to a vendor, for example, ways for improving their initial vendor models on the basis of working systems. The operator may offer to share this information freely or to provide them as a product for sale.

In further variations, updated vendor model 140 can be used for system verification and initial generation of the vendor model by vendors. Thus a vendor can take a system under development, place simulated capacity requirements on it and determine the values required for its databases.

In additional variations, one or more of the operator model, adaptation system 150, vendor model 115, updated vendor model 140 can be implemented on the same computing apparatus such as such as a server, a desktop computer, a virtual machine or any other apparatus, individual or distributed that will now occur to a person of skill in the art.

The many features and advantages of the invention are apparent from the detailed specification and, thus, it is intended by the appended claims to cover all such features and advantages of the invention that fall within the true spirit and scope of the invention. Further, since numerous modifications and changes will readily occur to those skilled in the art, it is not desired to limit the invention to the exact construction and operation illustrated and described, and accordingly all suitable modifications and equivalents may be resorted to, falling within the scope of the invention.

## Claims

1. A method, for a computing apparatus, of adapting virtualization resource requirements, the method comprising:
receiving performance indicators;
updating a model based on the received performance indicators.

2. The method of claim 1 further comprising:
generating, based on the updated model, updated resource requirement estimates for a virtualized application;
sending, to a cloud service provider, a capacity change request based on the updated resource requirement estimates.

3. The method of claim 2, wherein timing of the generating and sending is based on an update policy.

4. The method of claim 3, wherein the update policy is based on at least one schedule that reflects estimated capacity changes for a virtualized application, and optionally wherein the schedule is developed based on historical data.

5. The method of any preceding claim, wherein at least one of the performance indicators is received from a virtualized application, and optionally wherein the at least one of the performance indicators is based on one of a quality of service provided to users of the virtualized application and internal metrics on the operation of the virtualized application.

6. The method of any preceding claim, wherein the updating is based on a Kalman filter.

7. The method of any preceding claim, further comprising transforming the performance indicators into modification indicators.

8. The method of claim 7, wherein transforming is accomplished using fuzzy averaging techniques.

9. The method of claim 8, wherein the transforming further comprises providing performance estimates based on the performance indicators based on a predetermined value, wherein the fuzzy averaging techniques are performed based on the performance estimates, and optionally wherein each the performance estimate is associated with one or more related resources., and optionally wherein each the performance estimate associated with one or more resources has a corresponding confidence level associated with the one of more associated resources.

10. The method of claim 3, wherein the update policy further includes determining whether the updated model varies significantly from the model prior to updating.

11. The method of claim 2, wherein the updating also generates a request for scheduling the generating and sending.

12. The method of claim 2, wherein the sending is based on a signal by an operator model.

13. The method of any preceding claim, wherein the updating is further based on learning policies, and optionally wherein the learning policies are based on periods where a capacity needed approaches maximum capacity estimated by the model.

14. A computing apparatus for adaptive virtualization comprising:
an input device for receiving performance indicators; and
a processor configured for updating a model based on the received performance indicators.

15. The computing apparatus of claim 14, wherein the processor is further configured for generating, based on the updated model, updated resource requirement estimates for a virtualized system, the computing apparatus further comprising an output device for sending, to a cloud service provider, a capacity change request based on the updated resource requirement estimates.
